# EUROPEAN PATENT APPLICATION

(11) **EP 2 571 034 A1**
(43) Date of publication of application: **20.03.2013**
(21) Application number: 11181800.1
(22) Date of filing: 19.09.2011
(51) Int. Cl.: H01F 27/14

(54) **Subsea transformer enclosure**

(71) Applicant: Siemens Aktiengesellschaft, 80333 München (DE)
(72) Inventor: Boe, Ove, 7549 Tanem (NO); Haugan, Espen, 7052 Trondheim (NO); Stroemsvik, Torbjoern, 7030 Trondheim (NO)

(57) **Abstract**

A subsea transformer enclosure is provided. A transformer chamber of the subsea transformer enclosure is adapted to receive a transformer. A pressure compensation device is mounted to the transformer chamber and is adapted to provide pressure balancing between a dielectric liquid in the transformer chamber and an ambient medium surrounding the subsea transformer enclosure. A bushing chamber is further mounted to the transformer chamber, and a liquid tight seal is provided between the interior of the bushing chamber and the interior of the transformer chamber. The pressure compensation device comprises a first and a second pressure compensator.

## Description

### Field of the invention

The invention relates to a subsea transformer enclosure comprising a transformer chamber. It further relates to a subsea transformer comprising a subsea transformer enclosure.

### Background

Oil platforms are often used in offshore oil and gas production. More recently, processing facilities are being relocated to the ocean floor. Such subsea installations often require electric power to operate. Electric power can be produced subsea or can be transported to the subsea installation from a topside installation, e.g via an umbilical from an oil platform or ship, or via a subsea cable from an onshore site. Higher voltages are often used for transporting electric energy from the topside installation to the subsea installation, in particular to limit losses. Accordingly, a transformation to a lower voltage at which subsea equipment is to be operated is required. For this purpose, a subsea transformer can be provided at the subsea installation.

The subsea installation may be located at a great water depth, for example more that 1000, more than 2000 or even more than 3000 meters deep. The high pressures that prevail at such depths of water can be dealt with by providing a pressure resistant enclosure for the transformer, which is kept at a close to atmospheric pressure. The problem with such enclosures is that they are very bulky and heavy, as they need to withstand pressure differences up to 300 bar.

To overcome such problems, the transformer may be provided in an enclosure that is pressure compensated, in particular in which the inside pressure is equalized to the outside pressure. The pressure difference can thus be kept small, enabling the use of a lighter enclosure having thinner walls. Although this greatly facilitates the design of the enclosure, a number of problems remain.

To ensure a safe operation of the transformer, the transformer enclosure needs to be tightly sealed against the ambient sea water. In particular, a proper sealing of the enclosure means that providing pressure compensation may be difficult. Furthermore, the transformer needs to be contacted electrically. The electric connections through the enclosure to the transformer are again difficult to seal.

Enclosed volumes that are additionally provided for sealing either need to be provided with thick walls that are capable of withstanding the high outside pressures, or also need to be pressure compensated. Accordingly, pressure compensation of the transformer enclosure is difficult to implement, it can be complex in configuration and can require a considerable amount of space, making the transformer enclosure bulkier. Further, due to the technical complexity, the pressure compensation can be cost intensive to implement. Each pressure compensation furthermore requires sealing which is a potential weak point regarding the water-tightness of the subsea transformer enclosure.

It is thus desirable to simplify the pressure compensation of such enclosure, and to make it more compact and cost efficient. Furthermore, it is desirable to improve the sealing of the transformer enclosure.

### Summary

Accordingly, there is a need for an improved subsea transformer enclosure, which in particular provides good sealing while simplifying the pressure compensation.

This need is met by features of the independent claims. The dependent claims describe embodiments of the invention.

An embodiment of the invention provides a subsea transformer enclosure. The subsea transformer enclosure comprises a transformer chamber adapted to receive a transformer and a pressure compensation device mounted to the transformer chamber. The pressure compensation device is adapted to provide pressure balancing between a dielectric liquid in the transformer chamber and an ambient medium surrounding the subsea transformer enclosure. Furthermore, a bushing chamber is mounted to the transformer chamber, a liquid tight seal being provided between the interior of the bushing chamber and the interior of the transformer chamber. The bushing chamber comprises at least one electric connection to the interior of the transformer chamber and at least one electric connection to the outside of the subsea transformer enclosure. An electric contacting of a transformer in the transformer chamber from outside the subsea transformer enclosure is thus enabled. The pressure compensation device comprises a first and a second pressure compensator, the first pressure compensator being adapted to provide pressure balancing between the ambient medium surrounding the subsea transformer enclosure and an intermediate volume. The second pressure compensator is adapted to provide pressure balancing between the intermediate volume and the interior of the transformer chamber. The intermediate volume has a liquid tight seal against the outside of the subsea transformer enclosure and against the interior of the transformer chamber. The bushing chamber is pressure balanced against the intermediate volume.

By providing a first pressure compensator, an intermediate volume and a second pressure compensator, a double barrier for the pressure compensation device can be implemented, improving the protection against ingress of sea water. Similarly, by providing a bushing chamber which comprises the electric connection towards the transformer, a double barrier can be implemented for electric connections to the transformer. As the bushing chamber is pressure balanced against the intermediate volume, pressure balancing of the whole enclosure is simplified, while maintaining the double barrier. As the two pressure compensators can provide pressure compensation both for the transformer chamber and the bushing chamber, the assembly is compact and cost efficient to implement.

In an embodiment, the subsea transformer enclosure further comprises a fluid connection between the interior of the bushing box and the intermediate volume. The fluid connection provides the pressure balancing between the bushing chamber and the intermediate volume. The fluid connection may for example be a flow channel or a passage through which dielectric liquid can flow, enabling a fluid communication between the bushing chamber and the intermediate volume. The fluid connection may be provided in form of a compensation tube. The fluid connection provides a simple and effective means for pressure balancing.

In other embodiments, the subsea transformer enclosure may comprise a pressure balancing element for providing the pressure balancing between the bushing chamber and the intermediate volume, such as a movable piston, a membrane, a bladder, a bellow or the like.

The intermediate volume may at least partially be bordered by the first and second pressure compensators. The intermediate volume may be in fluid communication with the first and second pressure compensators. The intermediate volume may be enclosed or confined between the first and second pressure compensators.

In an embodiment, the second pressure compensator is arranged inside the first pressure compensator. The two pressure compensators thus provide a double barrier between the inside of the transformer chamber and the outside of the subsea transformer enclosure. The pressure compensators may be bellows. Accordingly, the pressure compensation a device may comprise double bellows, one bellow being arranged within the other. In such configuration, the intermediate volume is the volume between the double bellows, the bushing chamber being compensated against this volume.

By arranging the second pressure compensator inside the first pressure compensator, the intermediate volume can be confined between the first and second pressure compensators, and additionally by a wall of the transformer chamber. In other embodiments, the first and second pressure compensator may simply be in fluid communication, the intermediate volume being provided between them.

In an embodiment, the transformer chamber is provided by a transformer tank, the transformer tank being closed by a top plate. The bushing chamber and the pressure compensation device may be mounted to the top plate. Accordingly, assembly of the transformer enclosure can be facilitated, as the top plate can be pre-assembled and then simply be mounted to the transformer tank. Further, the transformer tank can be tailored to the size of the transformer, which results in a subsea transformer enclosure having a compact size.

The bushing chamber may be provided by a first structure, in particular a box shaped or cylindrical housing, which is mounted to the top plate. The pressure compensation device can be a second structure that is mounted to the top plate and spaced apart from the first structure. The bushing chamber and the pressure compensation device may thus enclose different volumes. In particular, the volume of the bushing chamber is different from the intermediate volume. The second structure may be a cylindrical structure or may be box shaped. The bushing chamber and the pressure compensation device can thus be mounted separately to the top plate, facilitating the assembly thereof.

In an embodiment, the pressure balancing between the bushing chamber and the intermediate volume may be provided by a fluid connection between the interior of the bushing box and the intermediate volume, wherein the fluid connection is provided by a flow channel in the top plate. Such configuration enables the mounting of the bushing chamber and the pressure compensation device to different positions on the top plate. At the same time, pressure balancing of the bushing chamber can be provided without additional pressure compensators, and a double barrier towards the interior of the transformer chamber can be ensured. Again, the flow channel may be provided in form of compensation tubes which allow dielectric liquid to flow through.

In an embodiment, the bushing chamber is provided by a bushing box. The bushing box may be sealed against and/or welded to the top plate. A compact design and a good sealing can thus be achieved. The bushing chamber may comprise no further electric components other than the electric connections for contacting the transformer.

In an embodiment, the subsea transformer enclosure comprises at least two bushing chambers, one bushing chamber providing electrical connections from outside the subsea transformer enclosure to a primary side of the transformer and one bushing chamber providing electrical connections from the outside of the subsea transformer enclosure to a secondary side of the transformer. In such configuration, a good insulation between the high voltage and low voltage sides of the subsea transformer may be achieved, in particular an improved isolation of the corresponding electric connections.

As an example, the subsea transformer enclosure may comprise at least two bushing chambers, each bushing chamber having at least three electric connections to the inside of the transformer chamber and the outside of the subsea transformer enclosure. Three-phase AC voltage may thus be supplied to or received from the transformer located inside the transformer chamber.

In an embodiment, the electric connection to the inside of the transformer chamber may be provided by a transformer bushing. The electric connection to the outside of the subsea transformer enclosure may be provided by a penetrator. This may be a high voltage penetrator, in particular for electric connections towards the high voltage side of the transformer. Inside the bushing chamber, a conductor can be provided which establishes electric contact between the two electric connections (i.e. the one to the outside transformer enclosure and the one to the inside of the transformer chamber).

The transformer bushing, the penetrator and/or the conductor may be covered by a boot seal. In case of ingress of seawater into the bushing chamber, additional protection may thus be provided for the electric connections inside the bushing chamber. Preferably, all three are covered by boot seals, thus improving the water resistance.

In an embodiment, at least one of the electric connections (i.e. the one to the outside of the subsea transformer enclosure or the one to the inside of the transformer chamber or both) comprises a double barrier. The double barrier may for example comprise two seals at the penetration of the bushing box through which the respective electric connection is provided. The two seals may for example be provided at the transformer bushing, or at the penetrator which penetrates through the wall of the bushing chamber. As an example, a radial seal and an axial seal may be provided, the seals may have the form of O-rings.

In another example, the double barrier may comprise a seal formed by welding an edge of a penetrator providing the respective electric connection to a wall of the bushing chamber. The wall of the bushing chamber may be a wall towards the ambient sea water or a wall towards the transformer chamber, e.g. the top plate of a transformer tank. The wall may comprise a penetrator adaptation onto which the penetrator is mounted, and welding may occur between the penetrator and the penetrator adaptation. A tight and a long lasting seal may be provided by welding.

In an embodiment, the subsea transformer enclosure comprises at least two pressure compensation devices. Each pressure compensation device may have a first and a second pressure compensator. In particular, each pressure compensation device may comprise double bellows, one bellow being arranged within the other. In such configuration, the pressure compensation arrangement can be kept compact while providing an adequate pressure compensation, i.e. while being capable of compensating volume changes of the dielectric liquid inside the transformer chamber, the bushing chamber and the intermediate volume.

In particular, the transformer chamber, the bushing chamber and the intermediate volume of the subsea transformer enclosure can be filled with dielectric liquid. Thus, electric isolation can be provided while the subsea transformer enclosure remains capable of being deployed at great depths of water.

A further embodiment of the invention provides a subsea transformer. The subsea transformer comprises a transformer enclosure in any of the above outlined configurations, and a transformer located in the transformer chamber of the transformer enclosure. The transformer in the transformer chamber can be contacted electrically via the electric connections provided by the bushing chamber.

By providing a subsea transformer having such subsea transformer enclosure, advantages similar to the ones outlined further above can be achieved.

The features of the embodiments of the invention mentioned above end those yet to be explained below can be combined with each other unless noted to the contrary.

### Brief description of the drawings

The foregoing and other features and advantages of the invention will become further apparent from the following detailed description read in conjunction with the accompanying drawings. In the drawings, like reference numerals refer to like elements.
Figure 1 is a schematic diagram illustrating a subsea transformer enclosure and subsea transformer in accordance with an embodiment of the invention.
Figure 2 is a sectional side view of a subsea transformer enclosure according to a further embodiment of the invention.
Figure 3 is a top view of the subsea transformer enclosure of figure 2.
Figure 4 is a perspective view of the subsea transformer enclosure of figures 2 and 3.
Figure 5 is a sectional side view illustrating the sealing of a penetrator to a wall of the bushing chamber in accordance with an embodiment.
Figure 6 is a sectional side view of the sealing of a penetrator to a wall of the bushing chamber in accordance with another embodiment.

### Detailed description

In the following, the embodiments illustrated in the accompanying drawings are described in more detail. It should be clear that the following description is only illustrative and non restrictive. The drawings are only schematic representations, and elements in the drawings are not necessarily to scale with each other.

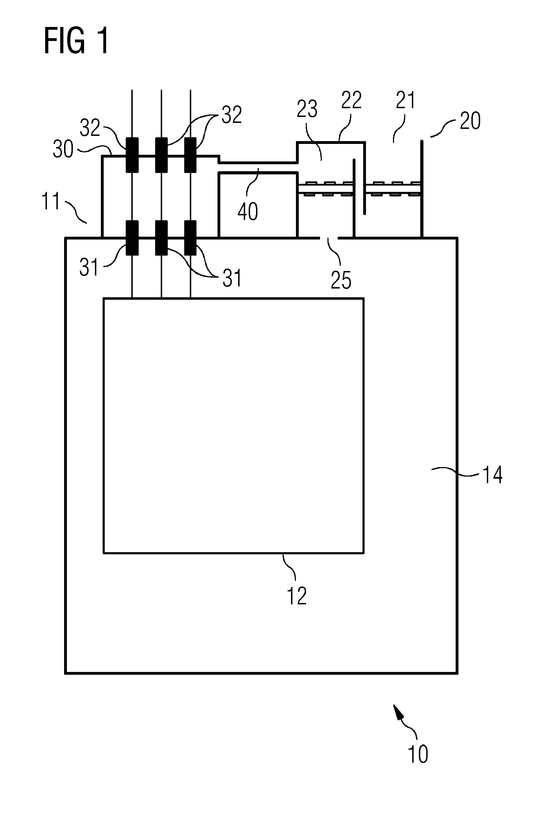

Figure 1 illustrates a subsea transformer enclosure 11 having a transformer chamber 14. In transformer chamber 14, a transformer 12 is arranged. Subsea transformer enclosure 11 and transformer 12 form a subsea transformer 10. Transformer 12 may for example be a step down transformer, which transforms a higher voltage supplied from a topside installation, e.g. a marine vessel or an onshore location, by an umbilical or a subsea cable into a lower voltage, which is then supplied to components of the subsea installation of which subsea transformer 10 forms a part.

The transformer which is housed in the subsea transformer enclosure 11 can be adapted to convert the subsea cable step out transmission voltage to the subsea switch gear distribution voltage.

Subsea transformer 10 and thus subsea transformer enclosure 11 are adapted to be deployed and operated at depth of water of more than 1000, more than 2000 or even more than 3000 meters. In particular, the subsea transformer enclosure 11 can be adapted to operate in a depth range of 1000 to 3000 meters.

For this purpose, the transformer chamber 14 is filled with dielectric liquid. The dielectric liquid provides electric isolation and furthermore transports heat from transformer 12 to the walls of the subsea transformer enclosure 11.

Subsea transformer enclosure 11 comprises pressure compensation device 20 mounted to transformer chamber 14. The pressure compensation device 20 comprises a first pressure compensator 21 and a second pressure compensator 22, with an intermediate volume 23 being bordered or confined by the first and second pressure compensators 21, 22. The intermediate volume 23 is also filled with dielectric liquid.

Each pressure compensator comprises a flexible element which is in figure 1 schematically indicated by the dashed lines. The flexible element of each pressure compensator provides a pressure balancing, in particular a pressure equalization between the media which it borders. The flexible element may for example be a membrane, a bladder, a bellow or the like. The first pressure compensator 21 provides pressure balancing between the ambient medium (e.g. sea water) surrounding the subsea transformer enclosure 11 and the intermediate volume 23, while the second pressure compensator provides pressure balancing between the intermediate volume 23 and the inside of transformer chamber 14, which is in fluid communication with the second pressure compensator 22 via the fluid connection 25, here an opening in the transformer chamber 14. Furthermore, the first pressure compensator 21 provides a fluid tight seal between the ambient medium and the intermediate volume 23, and the second pressure compensator 22 provides a fluid tight seal between the intermediate volume 23 and the inside of the transformer chamber 14.

Filling the intermediate volume 23 and the transformer chamber 14 with dielectric liquid has the advantage that if the pressure outside the subsea transformer enclosure 11 is increased, only small volume changes of the dielectric liquid confined in the transformer chamber 14 or in the intermediate volume 23 result. The flexible element of the pressure compensators 21, 22 transmit the increased outside pressure to the intermediate volume 23 and to the transformer chamber 14, respectively, as the flexible elements can be deformed and can thus compensate for volume changes. Pressure compensators 21 and 22 may thus also be termed volume compensators. Note that if the transformer chambers were filled with a gas, an increase of the ambient pressure by a factor of 2 would lead to a volume reduction of factor 2, which is difficult to compensate for by a pressure compensator.

Furthermore, the pressure compensators 21, 22 also compensate for changes of a volume of the dielectric liquid which may be caused by temperature changes. This can be of particular importance during transport of the subsea transformer 10. Without the flexible element of the respective pressure compensator, a change in temperature would lead to a change of volume, which may result in a drastic increase in pressure inside the transformer chamber 14, for example if the dielectric liquid expands. By means of the flexible element of the pressure compensator, such volume expansion or retraction can be allowed, while keeping the pressure inside the transformer chamber 14 balanced to the outside pressure.

It should be noted that "pressure balance" does not necessarily mean that the pressure inside the transformer chamber 14 and the pressure outside the subsea transformer enclosure 11 are exactly the same. A small pressure difference may be maintained, for example by biasing the flexible element of one or more of the pressure compensators. This is advantageous as for example if a small overpressure is maintained in transformer chamber 14, the ingress of e.g. sea water from the surroundings of the subsea transformer enclosure 11 can be prevented, as dielectric liquid will flow out through the leak due to the overpressure. A biasing can for example be achieved by making use of a weight placed on top of a bellow, by biasing a bellow by means of a spring, by biasing a membrane or the like.

Pressure compensators 21, 22 thus compensate for volume changes which would otherwise result in pressure imbalances between the inside of transformer chamber 14 and the outside of subsea transformer enclosure 11.

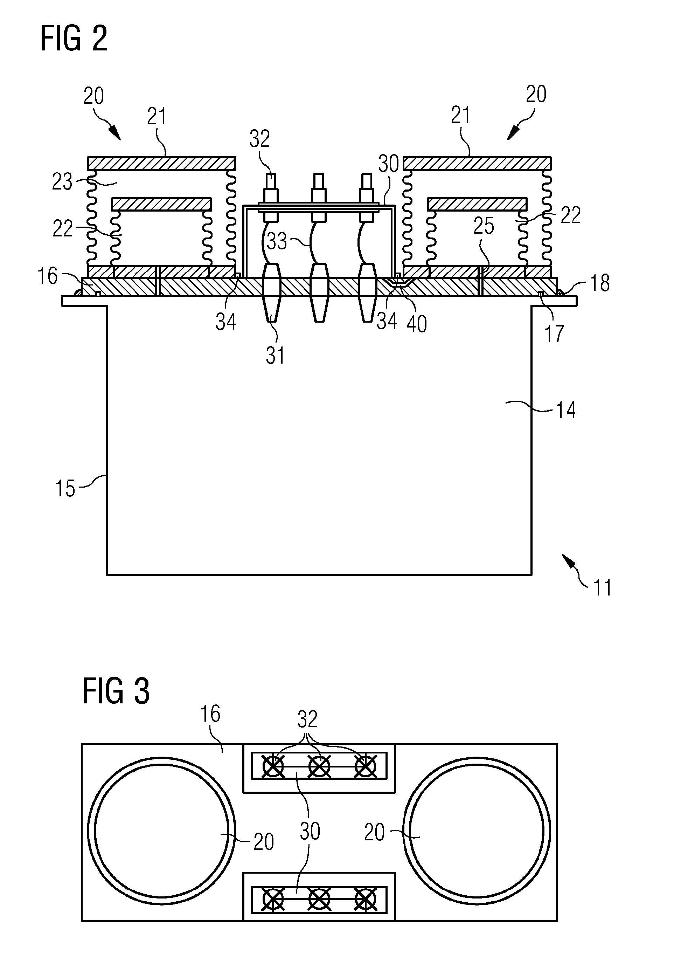

For electrically contacting transformer 12, a bushing chamber 30 is mounted to the transformer chamber 14. Bushing chamber 30 provides electric connections 31 to the inside of transformer chamber 14 and electric connections 32 to the outside of the subsea transformer enclosure 11. A sea cable connection may for example be terminated at the electrical connections 32. In particular, a jumper cable may be connected to electric connections 32 and may on its other side be connected to an umbilical termination assembly (UTA). The umbilical termination assembly may terminate an umbilical which connects to a topside installation on a vessel or at an onshore site. For a long lifetime, the jumper cable may be connected via dry mate connectors to the electric connections 32. Inside bushing chamber 30, an electric conductor connects the electric connections 31 and 32, which is explained further below in more detail with respect to figure 2. Via the electric connections 31, transformer 12 is electrically contacted.

The volume enclosed by bushing chamber 30 is filled with dielectric liquid. The inner volume of bushing chamber 30 is pressure balanced against the intermediate volume 23. In the example of figure 1, a fluid connection 40 is provided between the bushing chamber 30 and the intermediate volume 23. Fluid connection 40 enables the dielectric liquid to flow between the bushing chamber 30 and the intermediate volume 23. Thus, by means of the first pressure compensator 21, the interior of the bushing chamber 30 is pressure balanced against the ambient medium surrounding the subsea transformer enclosure 11.

Note that in other embodiments, other means for pressure balancing between the bushing chamber 30 and the intermediate volume 23 may be provided. As an example, pressure balancing may occur by means of a movable piston, a flexible element such as a bladder, a membrane, a bellow or the like.

As can be seen from figure 1, each opening in transformer chamber 14 that needs to be sealed is protected by a double barrier. Connections between a wall of a pressure compensator and the transformer chamber 14 can be welded and thus do not need to be provided with a double barrier. Sealings are provided at each penetration of the bushing chamber 30 for providing the electric connections, and at the mounting positions of the flexible elements of pressure compensators 21, 22. The flexible element of the first pressure compensator 21 provides a first seal against the ambient medium, while the flexible element of the second pressure compensator 22 provides a second seal, so that transformer chamber 14 is protected by a double barrier against ambient sea water. Similarly, the sealings of the electric connections 32 provide a first barrier, and the sealings of the electric connections 31 provide a second barrier for the transformer chamber 14.

The configuration illustrated in figure 1 thus achieves a double barrier sealing for the transformer chamber 14, while on the requiring a simple compensator arrangement. In particular, by making use of only two pressure compensators, a double barrier pressure compensation for the inside of transformer chamber 14 is achieved, and a pressure compensation for the inside of bushing chamber 30 is achieved.

Note that the arrangement of the pressure compensators 21, 22 is only schematically illustrated in figure 1, so that the general function and purpose of the pressure compensation device 20 becomes clear. As mentioned above, the pressure compensators 21, 22 can be configured in a variety of different ways, they may be arranged distant to one another, or one within the other, and may comprise different means for pressure compensation.

Figure 2 shows a particular implementation of the subsea transformer enclosure 11 described above with respect to figure 1. Accordingly, the explanations given above are similarly applicable to the subsea transformer enclosure 11 of figure 2 and described hereinafter.

In the example of figure 2, the transformer chamber 14 is implemented by means of a transformer tank 15 which is closed by a top plate 16. The transformer tank is provided by a single completely welded wall which is adapted to effectively transport the heat losses of the transformer to the ambient sea water. The top plate 16 covering the transformer tank 15 can be a steel plate. In an embodiment, the top plate 16 can be sealed against the transformer tank 15 by means of a seal 17, and/or top plate 16 may be welded to transformer tank 15 (as indicated by reference symbol 18). By welding the top plate to the transformer tank 15, double bearing sealings are not needed at this joint.

In the example of figure 2, the pressure compensation device 20 comprises pressure compensators 21, 22 in form of two bellows, wherein the second bellow 22 is placed within a first bellow 21. The intermediate volume 23 is thus confined between the two bellows 21, 22. The fluid connection 40 between the interior of the bushing chamber 30 and the intermediate volume 23 is provided by a flow channel. These so called "compensation tubes" allow the dielectric liquid to flow between the intermediate volume 23 and the inside of the bushing chamber 30. Fluid connection 25 between the interior of the second bellow 22 and the inside of transformer chamber 14 is similarly provided by a compensation tube.

For the purpose of redundancy and for achieving a compact configuration, the pressure compensation device 20 comprises a first and a second pressure compensation device, each having two bellows 21, 22, one placed within the other. If one pressure compensation device fails, the other can still provide pressure compensation. Further, each pressure compensation device can be smaller than one large volume pressure compensation device, making each pressure compensation device less prone to damage.

The external electric power connections from and to the transformer (in particular to the primary and secondary side of the transformer) are grouped into two separate dielectric liquid filled bushing chambers 30. In the side view of figure 2, only one bushing chamber is visible. The second bushing chamber can be seen in figure 3, showing a top view of the subsea transformer enclosure 11 of figure 2.

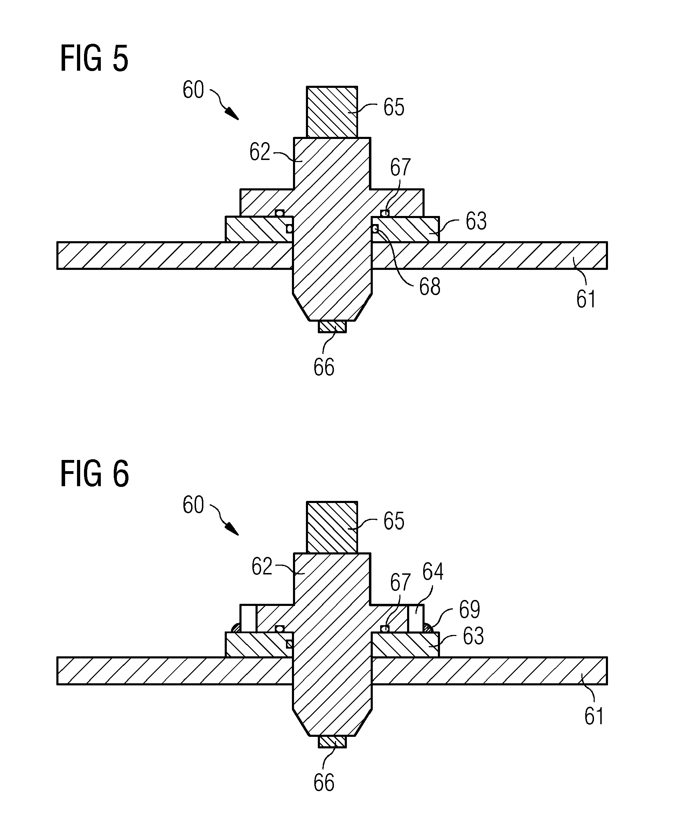

The bushing chamber 30 is provided in form of a bushing box. The bushing box acts as a double barrier to the ambient sea water as seen from the inside of transformer chamber 14. The electric connections 31 to the inside of the transformer chamber 14 are provided in form of transformer bushings. They penetrate the lower wall of the bushing box 30 (i.e. the top plate 16) and provide a through connection for an electric conductor (not shown in figure 2; see figures 5 and 6).

The electric connections 32 to the outside of the subsea transformer enclosure 11 are provided by penetrators, which may be high voltage penetrators, and which can attach to a jumper cable by means of dry mate connectors.

In other configurations, the penetrators may be medium voltage penetrators. A high voltage may be a voltage in a range between about 50 kV and about 200 kV. A medium voltage may be a voltage in a range between about 1.000 V and about 50 kV. On the primary side of the transformer, high voltage penetrators may be used while on the secondary side, medium voltage penetrators may be used.

An electric conductor 33 is provided between the transformer bushings 31 and the penetrator 32. The conductor 33 and/or the transformer bushing 31 and/or the penetrator 32 may be provided with boot seals. In case of leakage of sea water into the bushing box 30, the boot seals can provide a water resistance. This can prevent that a flashover occurs in the case of water leakage into the bushing box. The boot seals prevent the water from coming into contact with the conductors.

Another possibility to improve the protection of the electric connections from sea water is the use of double barriers in each penetration of a wall of bushing chamber 30. This is illustrated in figures 5 and 6.

In the example of figure 5, the penetrator 62 is provided with an axial sealing 68 and a radial sealing 67. The wall 61 of the bushing chamber comprises a penetrator adaptation 63, against which the penetrator 62 is sealed. The seals 67, 68 may for example be provided in form of O-rings. Reference numeral 65 designates the electric connection towards the sea cable, or towards the conductor 33 in the bushing chamber, while reference numeral 66 designates the electric connection to the inside of the bushing chamber, or to the inside of the transformer housing, respectively. Each of the electric connections 31, 32 can be configured similar to the electric connection 60 shown in figure 5. Penetrator 62 may be made of a resin or a plastic material and provides electric isolation between the wall 61 of the bushing chamber and the electric conductor (indicated by reference numerals 69 and 66) in the penetrator.

Figure 6 illustrates another possibility of implementing the electric connections 31, 32 with a double barrier. In the configuration of figure 6, the electric connection 60 comprises a radial sealing 67 in form of an O-ring. Furthermore, a radial edge 64 of the penetrator 62 is metalized. The metalized penetrator edge 64 is welded to the penetrator adaptation 63 (indicated by reference numeral 69). This configuration provides a liquid tight seal and a double barrier. Again, the configuration of figure 6 may be used in any of the electric connections 31, 32.

Figure 3 shows a top view of the subsea transformer enclosure 11 of figure 2. The two pressure compensation devices 20 are mounted to the top plate 16. Furthermore, the two bushing boxes 30 can be seen, with the electric connections 32 towards which a sea cable can be connected. From each bushing chamber 30, a fluid connection can be provided to the intermediate volume of either one of the pressure compensation devices 20, or to the intermediate volume of both pressure compensation devices 20. It is also possible to provide from one bushing chamber 30 a fluid connection to one pressure compensation device 20, and to provide a fluid connection from the other bushing chamber 30 to the other pressure compensation device 20. If water enters one of the bushing chambers or pressure compensation devices, the others will remain unaffected. On the other hand, if connections to both pressure compensation devices 20 are provided, pressure compensation continues even if one of the pressure compensation devices fails.

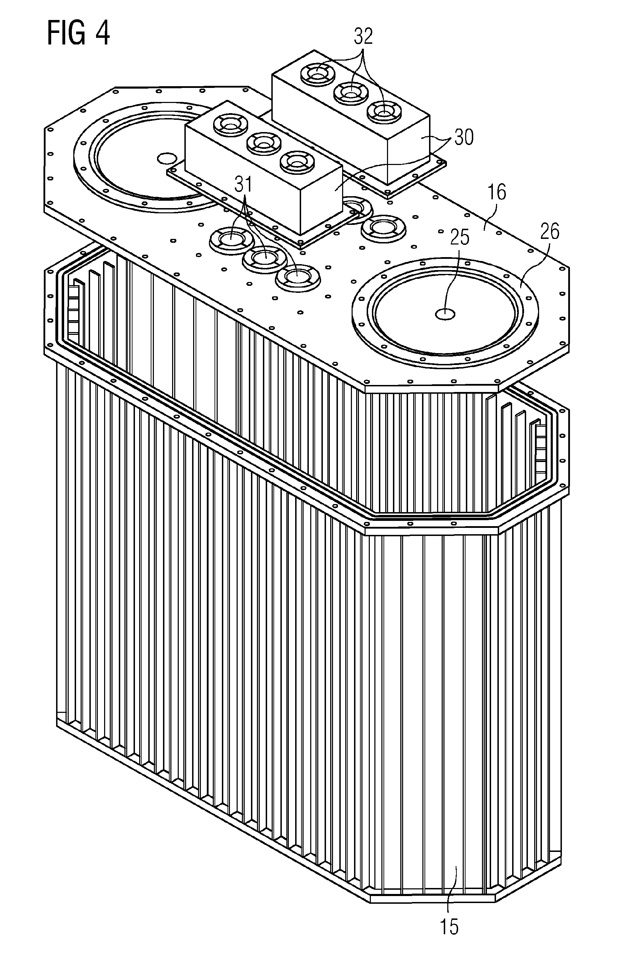

Figure 4 shows a perspective view of the subsea transformer enclosure 11 of figures 2 and 3. The transformer tank 15 is provided with cooling ribs inside and outside to ensure that heat losses of the transformer are effectively transported to the sea water. The transformer tank 15 can be relatively thin walled, as the differential pressure between inside the transformer chamber 14 and the surrounding medium is kept minimal due to the pressure compensation. As mentioned above, the internal overpressure may result from biasing the pressure compensators, and the transformer tank 15 only needs to be constructed to withstand the maximum internal overpressure. The overpressure ensures that an accidental leakage in a system will not result in any water inside the transformer chamber. The dielectric liquid will, to a limit, leak out into the sea water. This way, it is also possible to detect a leakage before a large failure occurs, like a short circuit inside the transformer.

As can be seen, the top plate 16 comprises the fluid connections 25 between the transformer chamber and the inside of the second pressure compensator (bellow) 22. Reference numeral 26 indicates the mounting position of the double bellow pressure compensation device. Bushing boxes 30 have a flange by means of which they are mounted to the top plate 16. The bushing box may furthermore be welded to the top plate 16.

The transformer tank 15 can be shaped so that the volume of dielectric liquid can be kept to a minimum, i.e. the shape can be adapted to the shape of the transformer which it houses. The transformer tank 15 and the top plate 16 can be made of carbon steel. The pressure compensation devices may be made of stainless steel, or a comparable material, such as Inconel® 625.

As can be seen, the double bellows provide a double barrier against the ambient sea water. Furthermore, as explained above, the penetrations of the bushing box 30 may be provided with double barriers. A high reliability against the ingress of sea water into the transformer chamber 14 can thus be achieved. Also, the subsea transformer enclosure 11 is compact and easy to assemble. By providing such configuration, the transformer lifetime can be increased, reducing the need for maintenance or service operations during the transformer's lifetime, which are generally cost intensive for subsea installations.

## Claims

1. A subsea transformer enclosure, comprising
- a transformer chamber (14) adapted to receive a transformer (12),
- a pressure compensation device (20) mounted to the transformer chamber (14) and adapted to provide pressure balancing between a dielectric liquid in the transformer chamber (14) and an ambient medium surrounding the subsea transformer enclosure (11);
- a bushing chamber (30) mounted to the transformer chamber (14), wherein a liquid tight seal is provided between the interior of the bushing chamber (30) and the interior of the transformer chamber (14), the bushing chamber (30) comprising at least one electric connection (31) to the interior of the transformer chamber and at least one electric connection (32) to the outside of the subsea transformer enclosure, so as to enable an electric contacting of a transformer (11) in the transformer chamber (14) from outside the subsea transformer enclosure (11),
wherein the pressure compensation device (20) comprises a first and a second pressure compensator (21, 22), the first pressure compensator (21) being adapted to provide pressure balancing between the ambient medium surrounding the subsea transformer enclosure and an intermediate volume (23), the second pressure compensator (22) being adapted to provide pressure balancing between the intermediate volume (23) and the interior of the transformer chamber (14), the intermediate volume (23) having a liquid tight seal against the outside of the subsea transformer enclosure and against the interior of the transformer chamber, wherein the bushing chamber (30) is pressure balanced against the intermediate volume (23).

2. The subsea transformer enclosure according to claim 1, further comprising a fluid connection (40) between the interior of the bushing chamber (30) and the intermediate volume (23) for providing the pressure balancing between the bushing chamber and the intermediate volume.

3. The subsea transformer enclosure according to claim 1 or 2, wherein the second pressure compensator (22) is arranged inside the first pressure compensator (21), the pressure compensators being preferably bellows.

4. The subsea transformer enclosure according to any of the preceding claims, wherein the transformer chamber (14) is provided by a transformer tank (15), the transformer tank being closed by a top plate (16), wherein the bushing chamber (30) and the pressure compensation device (20) are mounted to the top plate (16).

5. The subsea transformer enclosure according to claim 4, further comprising a fluid connection (40) between the interior of the bushing chamber (30) and the intermediate volume (23) for providing the pressure balancing between the bushing chamber and the intermediate volume, wherein the fluid connection (40) is provided by a flow channel in the top plate (16).

6. The subsea transformer enclosure according to claim 4 or 5, wherein the bushing chamber (30) is provided by a bushing box which is sealed against and/or welded to the top plate (16) .

7. The subsea transformer enclosure according to any of the preceding claims, comprising at least two bushing chambers (30), one bushing chamber providing electric connections from outside the subsea transformer enclosure (11) to a primary side of the transformer (12) and one bushing chamber providing electric connections from the outside of the subsea transformer enclosure (11) to a secondary side of the transformer (12).

8. The subsea transformer enclosure according to any of the preceding claims, wherein the electric connection (31) to the inside of the transformer chamber (14) is provided by a transformer bushing and/or wherein the electric connection (32) to the outside of the subsea transformer enclosure (11) is provided by a penetrator (62), in particular a high or medium voltage penetrator, wherein a conductor (33) inside the bushing chamber connects the electric connection (31) to the inside of the transformer chamber with the electric connection (32) to the outside of the subsea transformer enclosure.

9. The subsea transformer enclosure according to claim 8, wherein at least one of the transformer bushing, the penetrator or the conductor is covered by a boot seal.

10. The subsea transformer enclosure according to any of the preceding claims, wherein at least one of the electric connections (31, 32) comprises a double barrier.

11. The subsea transformer enclosure according to claim 10, wherein the double barrier comprises two seals (67, 68) at the penetration of the bushing chamber (30) which provides the respective electric connection (31, 32) to the inside of the transformer chamber or to the outside of the subsea transformer enclosure.

12. The subsea transformer enclosure according to claim 10, wherein the double barrier comprises a seal (69) formed by welding an edge of a penetrator (62) providing the respective electric connection (31, 32) to a wall (61, 63) of the bushing chamber (30).

13. The subsea transformer enclosure according to any of the preceding claims, comprising at least two pressure compensation devices (20), each having a first and a second pressure compensator (21, 22).

14. The subsea transformer enclosure according to any of the preceding claims, wherein the transformer chamber (14), the bushing chamber (30) and the intermediate volume (23) are filled with dielectric liquid.

15. A subsea transformer comprising a subsea transformer enclosure (11) according any of claims 1-14 and a transformer (12) located in the transformer chamber (14) of the subsea transformer enclosure (11).
